# EUROPEAN PATENT APPLICATION

(11) **EP 0 738 896 A2**
(43) Date of publication of application: **23.10.1996**
(21) Application number: 96302717.2
(22) Date of filing: 18.04.1996
(51) Int. Cl.: G01R 33/09

(54) **Exchange coupled barber pole magnetoresistive sensor**

(30) Priority: 19.04.1995 US 424914
(71) Applicant: EASTMAN KODAK COMPANY, Rochester, New York 14650-2201 (US)
(72) Inventor: Smith, Neil, c/o Eastman Kodak Co., Rochester, New York 14650-2201 (US)
(74) Representative: Jones, Alan John

(57) **Abstract**

Biasing of a BP MR sensor is disclosed in which single domain stability is achieved by use of conductive strips made of bilayers of an antiferromagnetic exchange pinning material and a high conductivity non magnetic metallic layer which overlays the pinning material, the bilayer strip being geometrically oriented at approximately 45° to the longitudinal axis of the MR film. Deposited first, directly on top of the MR film, the pinning material exchange couples to the MR layer and is aligned to pin the MR magnetization underneath the slanted strip along the longitudinal axis of the MR film. The high conductivity component of the bilayer strip is designed to reduce the net sheet resistivity of the strip to be very much less than that of the MR film. With the pinning direction aligned along a single direction longitudinal to the MR film easy axis, the exchange pinning strip aligns and stabilizes the MR magnetization underneath the strips to remain longitudinal, which through intrinsic anisotropy and internal magnetostatic and exchange coupling aligns and stabilizes a single domain longitudinal bias magnetization in all active regions between strips.

## Description

### BACKGROUND OF THE INVENTION

### 1. Field of the Invention

This invention relates to magnetoresistive (MR) sensors, and in particular to MR sensors utilizing "barber-pole" biasing of the MR element.

### 2.Description Relative to the Prior Art

A magnetoresistive (MR) field sensor may be used to detect magnetic fields for a wide range of applications, ranging from detecting weak, uniform magnetic fields generated by remote objects (e.g. submarines, geologic anomalies) to the large but extremely localized fields from a disk or tape magnetic medium used for high density information storage. Intermediate examples are position/motion detectors (e.g. encoders, accelerometers) which sense the change in magnetic fields from a permanent magnet in motion relative to the MR sensor, or document (e.g. currency) authentication systems which detect the stray fields from the magnetic component of the ink used to print the document. MR sensors have the advantage (compared to inductive devices) in maintaining large field sensitivity that is independent of the frequency (from dc to over 100 MHz) of the signal field to be detected. MR sensors also have the property that the output signal is dependent upon their magnetization state at their operating (bias) point.In typical applications employing thin magnetic films exhibiting anisotropic magnetoresistance (AMR), it is desirable to maintain the MR sensor in a stable, single domain bias magnetization state with the magnetization vector at roughly 45° to the sense current to maximize sensitivity and linear dynamic range, avoid the well known Barkhausen noise, and insure reproducible output signal for the given input signal field to be detected.

One method of arranging the 45° bias angle is the "barber pole" (BP) configuration known in the art (U.S. Patent # 4,052,748) which discloses a thin-film MR element in the shape of an elongated parallelogram, (usually a rectangle), which is designed to detect signal fields transverse to (and in the plane of) the longitudinal axis of the MR element. On top of the MR film there are (deposited) a periodic array of high conductivity strips slanted at about 45° with respect to the MR element's longitudinal axis. Current flow in the active area of the MR element (between the strips) flows at roughly 90° to the high conductivity strips, which is again at about 45° to the MR film's longitudinal axis. The longitudinal axis is also the easy axis of magnetization for the MR element, and along which the magnetization will prefer to be aligned at the quiescent bias point. However, this preference is axial, not directional ( left or right along the longitudinal axis), and the basic barber pole design may not always be stable against formation of metastable multidomain states with magnetization in different regions of the MR film separated by domain walls along opposite longitudinal directions. While domain wall motion in multidomain bias states gives rise to Barkhausen noise in all MR sensor designs, the BP design in particular is susceptible to signal loss when not in a single domain state, since the signal contributions from oppositely magnetized domains tend to cancel one another.

One stabilization method disclosed in IBM Technical Disclosure Bulletin, vol.20,pp.791-793, July 1977, comprises a bilayer slanted conduction strip consisting of a first layer of either nonmagnetic or soft magnetic conductive material, and a second layer of magnetically hard permanent magnet (PM) material that is magnetized along the longitudinal direction of the MR film. It is probable that the utility of this method is limited as the fields generated by the PM strip layer on the MR film will reverse longitudinal direction at or near the edge of the strip, which cannot provide for a unique direction of stability throughout the MR film, and in fact will likely be a source of generation of undesirable domain walls at or near the strip edges. Further, the stray fields from the PM strips are not locally confined to the strip region, and can be large enough in the active region between the strips to substantially and negatively impact the field sensitivity of the MR film.

Another stabilization method is disclosed In U.S. Patent # 4,639,806 which teaches the use of monolayer slanted strips consisting of PM material (CoP) in contact with and exchange coupled to the MR film. The sheet resistivity of the PM materials is likely to be comparable to the resistivity of the MR film, and such slanted strips are not likely to act as effective equipotentials whereby the current flow between strips is perpendicular to the long axis of the strips.The embodiments disclosed in the prior art recommend that the PM strips be magnetized either parallel, or perpendicular to the longitudinal axis of the strips, which in either case is roughly at 45° to the longitudinal axis of the MR film. Because the strips are exchange coupled to the MR film below, they force the magnetization underneath the strips to be misaligned with the MR film longitudinal axis ( i.e., the optimum stability direction), which will, through magnetostatic plus internal exchange stiffness also result in some degree of misalignment of the magnetization in the active sensor region between strips. The stray fields of the PM strips will also contribute to misalignment, and it is likely to significantly reduce MR sensitivity as described above.

In IEEE Trans. Magn., vol. 18, pp. 1149-1151 1982, Tsang and Fontana describe the use of a FeMn exchange pinning layer deposited everywhere on top of a NiFe (PERMALLOY) AMR film prior to deposition and patterning of Ti-Au conductive BP strips. The antiferromagnetic FeMn pinning layer was aligned to pin the MR magnetization along the longitudinal axis of the MR film, with an effective exchange field of about Hₑₓ=24 Oe. It was shown that this approach was effective in stabilizing single domain in the MR film and grossly reducing the Barkhausen noise that was observed without the pinning layer. However, placing the pinning layer in the active region between the slanted strips will in general result in loss of sensitivity of the device. With exchange fields Hₑₓ of tens of Oersteds ( the larger the better for guaranteeing stability), this loss in sensitivity will most likely be substantial, and be accompanied by a loss of linear dynamic range (i.e., increase in odd order nonlinear distortion) of the MR response transfer function which in general results when using longitudinal stabilization fields on BP sensors designed to measure transverse fields. The FeMn layer will in this case also serve to shunt some fraction of the sensing current, thereby also reducing the net magnetoresistive signal output.

Tsang (IEEE Trans Magn., vol.25, pp. 3692-3694 and U.S. Patent #4,633,685) discloses the use of patterned exchange end-tabs for longitudinally exchange pinning only the end regions of an MR film sensor/head. U.S. Patent # 3,533,685 does not discuss application to the slanted conducting strips of a BP sensor. Fig. 5 of the above referenced journal article discloses results for a stabilized "barber-pole-biased" MR reproduce head. However, in this case, the exchange pinning tabs were at the longitudinal ends of the MR element, and were external to the slanted conducting current leads which defined the central active reproduce trackwidth. Further, this device had no additional slanted conducting strips in the active area, and is applicable only to sensor geometries where the MR film height is comparable to the active sensor trackwidth.

### SUMMARY OF THE INVENTION

Rather than covering the entire MR film with an exchange coupled pinning layer or using exchange coupled pinning tabs at the longitudinal ends of the MR layer as taught in the prior art, the present invention discloses biasing of a BP MR sensor in which single domain stability is achieved by use of conductive strips made of bilayers of an antiferromagnetic or ferrimagnetic exchange pinning material and a high conductivity non magnetic metallic layer which overlays the pinning material, the bilayer strip being geometrically oriented at approximately 45° to the longitudinal axis of the MR film. Deposited first, directly on top of the MR film, the pinning material exchange couples to the MR layer and is aligned to pin the MR magnetization underneath the slanted strip along the longitudinal axis of the MR film. The high conductivity component of the bilayer strip is designed to reduce the net sheet resistivity of the strip to be very much less than that of the MR film. With the pinning direction aligned along a single direction longitudinal to the MR film easy axis, the exchange pinning strip aligns and stabilizes the MR magnetization underneath the strips to remain longitudinal, which through intrinsic anisotropy and internal magnetostatic and exchange coupling aligns and stabilizes a single domain longitudinal bias magnetization in all active regions between strips.

Being antiferromagnetic, the exchange strips produce no external magnetic fields to either reduce intrinsic sensitivity, or misalign the bias magnetization in the active region away from the optimal longitudinal direction. Being only beneath the slanted strips the exchange layer does not directly couple to the MR film in the active layer, and so no significant loss in MR sensitivity is incurred regardless of the strength of the exchange pinning field Hₑₓ. As the sheet resistivity is low in comparison to the MR film, the bilayer slanted strips will help insure that current flow in the MR active region remains nearly perpendicular to the axis of the slanted strip, and thereby very near the optimal 45° to the direction of stabilized bias magnetization. With exchange pinned bias point magnetization longitudinal to the MR element and parallel to an intrinsic easy axis, maximum bias stability is achieved, and such a BP MR sensor has selective vector sensitivity only to signal fields transverse to the longitudinal axis of, and in the plane of, the MR film. The exchange pinning of the magnetization underneath the slanted strips also reduces or eliminates undesirable self-bias effects from the transverse magnetic fields produced by the longitudinal current flow in the slanted strips.

### BRIEF DESCRIPTION OF THE DRAWINGS

The invention will be described with respect to the drawings of which:
Fig. 1 is a perspective drawing of the invention,
Fig. 2 is drawing illustrating the magnetization direction and the current flow in the MR layer of the invention,
Fig. 3a is a drawing of a center tapped second embodiment of the invention,
Fig. 3b is a schematic of a differential detection circuit to provide an output from a center tapped embodiment of the invention,
Fig. 3c is a schematic of a bridge circuit to provide an output from a center tapped embodiment of the invention, and
Fig. 3d is a drawing of a center tapped third embodiment of the invention.

### DESCRIPTION OF THE PREFERRED EMBODIMENTS

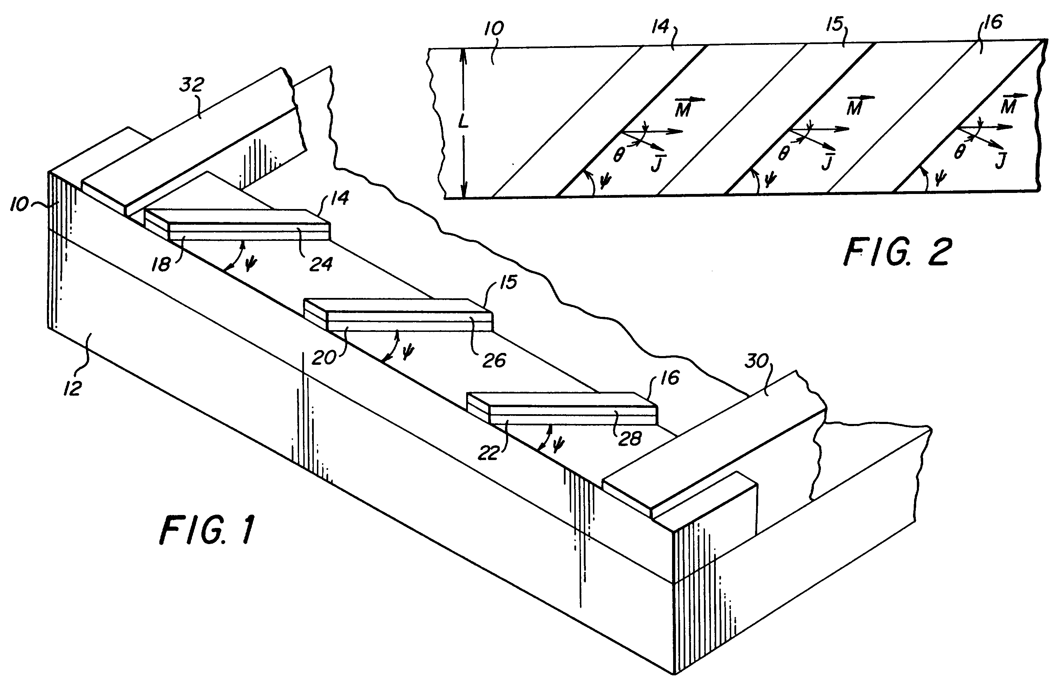

Referring to Fig.1, an elongated MR layer 10 is deposited upon a substrate 12. The MR layer 10 is preferably NiFe (PERMALLOY) and typically the thickness of the MR layer 10 is approximately 250 angstroms. Bilayer strips e.g., 14, 15, 16 are deposited across the MR layer 10 with the axes of the strips e.g.,14,15, 16 approximately at a slant angle Ψ of 45°, with the longitudinal direction of the MR strip 10. Each bilayer strip 14, 15,16 is fabricated with a antiferromagnetic exchange pinning layer 18,20,22 deposited directly on the MR layer 10. Geometrically congruent conducting layers 24,26,28 are deposited directly over the antiferromagnetic pinning layers 18, 20,22 to complete the bilayer strips 14,15,16. The antiferromagnetic pinning layers 18,20,22 are typically of FeMn, deposited in thickness of from 100-300 angstroms. The conducting layers 24,26,28 are typically deposited Au in thickness of 0.1 to 1.0 microns. External current leads 30,32 of Au are deposited to provide contact to the longitudinal ends of the MR layer 10. The contact area of current leads 30,32 with MR layer 10 may also consist of a bilayer with exchange pinning material directly in contact the MR film 10. The slanted bilayer strips e.g. 14, 15,16 and end contact regions may be constructed photolithographically using a lift-off process known in the art.

A Ta adhesion layer may be deposited on the substrate prior to the deposition of the MR layer, and a final dielectric passivation layer (e.g., SiO₂) may be deposited over the rest of the structure, in a manner known in the art.

The MR element and exchange layer are deposited in the presence of a magnetic field that is aligned along the direction that will define the longitudinal axis of the MR layer. Post deposition annealing in an external field magnetic field aligned in the same direction may be optionally employed to enhance the exchange coupling strength. For example, Chen et al (U.S. Patent #5,262,914 and IEEE Trans. Magn., vol. 29, pp. 4077-4079, 1993) discloses the deposition of Au on top of FeMn (< 200 angstroms thick) exchange coupled to NiFe can improve the exchange coupling between the latter, and that additional annealing cycles can even further increase the coupling. Lin et al in U.S. Patent # 5,315,468 teach that yet substantially stronger exchange coupling can be achieved using a NiFe-NiMn exchange coupling pair, although in this case post-deposition anneal is definitely required. (If necessary, a thin film of Ta may be deposited prior to the Au to prevent interdiffusion of the Au into the NiMn during annealing.) Because NiMn is much less corrosive than FeMn, it is more suitable for applications where some part of the BP slanted strips are exposed to the environment (e.g., a magnetic recording head at the head-medium interface). The increased Hₑₓ available from NiFe-NiMn (compared to FeMn) further insures single domain stability without, as noted earlier, any loss in sensitivity from the BP MR design taught herein.

Referring to Fig. 2, in a good barber pole design, the slant strip 14,15,16 width b is less than, or comparable to, the active MR width d, which in turn is less than, or comparable to, the height L of the MR layer 10. Further, the design must maintain the angle 8 between the bias magnetization M and sheet current density J at or near 45 ° . If ρ is the sheet resistance of the MR layer 10, and ρ' is the combined parallel sheet resistance of slant strip e.g. 14 and the MR layer 10, then in general, the geometry b:d:L=1:1:1 with ρ/ρ'≤1/20 and 40°≤Ψ≤θ≤45°, is roughly optimal for most applications.

The BP MR herein described is particularly well suited for applications requiring an MR sensor for detecting moderate (<100 Oe) to small magnetic fields (∼1mOe) from either remote sources, or from moderate to low density magnetic recording applications, such as reading signals from the magnetic stripes on credit/bank cards, or documents that are printed with magnetic ink. In these applications, unshielded BP MR sensors with MR film heights L≥10µm are suitable, particularly for wide trackwidth applications where the width W>L and W>100µm, and where as described by Tsang, simply exchange pinning only the ends of a conventional AMR film was insufficient to maintain single domain stability over the central region. By contrast the periodic exchange slant strip pinning the BP MR of the present invention works equally well for arbitrarily long trackwidths W. Being unshielded, the high conductivity layer of the slanted strips can be made reasonably thick (1/3-1 µm) to minimize the sheet resistivity of the slanted strips relative to the MR film.

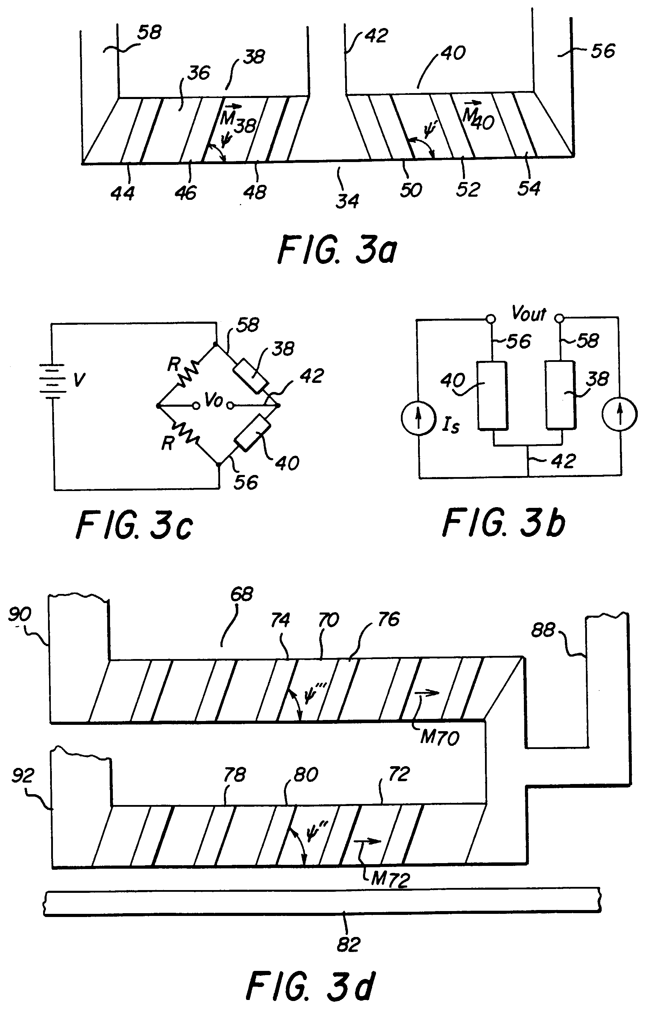

It is known in the art that differential detection of two oppositely biased MR sensors, electrically connected at a common "center-tapped" terminal, can reduce (if not eliminate) both the even order harmonic distortion and temperature fluctuation noise common to single element MR sensor designs. For the exchange pinned BP MR this is readily accomplished photolithographically, and may be incorporated in a second embodiment of the invention by orienting one half of the slanted barber-pole exchange/conductor strips as described supra at the supplementary angle Ψ'= 180°-Ψ. Referring to Fig. 3a, a center tapped MR sensor 34 consists of an MR layer 36 having two nominally identical half "legs" 38, 40 defined by and located on either side of a conductive center tap lead 42 electrically connected to the center of the MR layer 36. Deposited over the leg 38 are slanted bilayer strips e.g., 44,46,48 consisting of an exchange pinning layer overlaid by a conductive layer as described in the first embodiment of the invention, supra. The contact area of the lead 42 with the MR layer 36 may also consist of a similar bilayer composition. The strips e.g.44,46,48, on one side of the conductive lead 42, are at an angle Ψ with respect to a longitudinal edge of the MR layer 36. The strips 50,52,54, on the other side of the conductive lead 42, are at an angle Ψ'=180°-Ψ. (In the drawings, different but related elements are identified by the same reference character, albeit that the different elements are distinguished by primes.) Current leads 56,58 electrically contact the MR layer 36 at or near its ends, and define the active trackwidth of the sensor. For both leads 56,58 their contact area with the MR layer 36 may consist of a bilayer of exchange pinning material overlaid by a conductive layer as described supra. The magnetizations M₃₈ in leg 38, and M₄₀ in leg 40 are exchange pinned to be in the same longitudinal direction.

Referring to Fig.3b and Fig. 3c, the center-tapped MR sensor 34 can be incorporated into two prototypical detection circuits. Fig. 3b is a fully differential circuit with two matched current sources, and Fig. 3c, which is a simpler bridge circuit requiring only a single voltage source. In the circuit of Fig. 3b, sense current Iₛ enters each of the end leads 56,58, and leaves through the center tap lead 42, which needs to carry twice the current 2Iₛ. In the circuit of Fig. 3c, the sense current Is enters and leaves through the end leads 56,58. The center tap lead 42 nominally carries zero current, thereby primarily acting only as a voltage tap. Provided both legs 38 and 40 of the center tapped BP MR sensor 34 are sufficiently well coupled thermally so as to remain at the same temperature, the differential detection circuit (Fig. 3b) in principle provides perfect cancellation of temperature fluctuation noise, as well as any residual even-order harmonic distortion if θ≠45°. The bridge circuit of Fig. 3c also provides such cancellation, but only to first order in the magnetoresistive coefficient ΔR/R i.e., the cancellation may be inexact by a percentage amount of up to ΔR/R (≈2% at worst, for NiFe). For most applications this should be sufficient, particularly given the much greater simplicity of the bridge circuit (Fig. 3c), and its avoidance of a high current center tap.

A third embodiment of the invention is shown in Fig. 3d, where a configuration of a center tapped MR sensor 68 comprises MR legs 70,72 which, unlike the second embodiment described supra, are non-collinear. A center tap lead 88 is electrically connected between the legs 70,72, and end current leads 90, 92 are provided to feed sense current to the MR sensor 68. Slanted strips e.g. 74,76,78,80, which are bilayer pinning strips as disclosed supra, are provided at a slant angle Ψ''' on leg 70, and slant angle Ψ" on leg 72. The longitudinal component of the exchange pinned bias magnetizations M₇₀, M₇₂ of each leg, is the same in each leg 70,72. In the case Ψ'''= 180°-Ψ" the center tapped sensor 68 functions in a manner similar to the collinear sensor 34 described supra. In the case Ψ'''=Ψ" the MR sensor 68, when used in the detection circuits of Fig. 3b and Fig.3c will give no output in response to a common-mode (uniform) signal field seen equally by both legs 70,72. Such a sensor is useful in reading information from a magnetically recorded medium 82 in a high external magnetic noise environment, provided that the first leg (i.e. 72) is in sufficiently close proximity to the magnetically recorded medium 82 to be detected, while the second leg (i.e. 70) is sufficiently remote from the medium 82 so that it sees only a small fraction of the signal field seen by the first leg 72.For both cases Ψ'''= 180°-Ψ" or Ψ'''= Ψ", the MR sensor 68 also provides cancellation of temperature fluctuation noise.Compared to the MR sensor 34, the closer proximity of the two legs of the MR sensor 68 may, in some circumstance, provide better thermal contact between the legs 70,72 thereby minimizing their difference in temperature. It is also possible to combine the designs of the MR sensors 68 and 34 so that each leg of MR sensor 68 is itself a center tapped sensor the same as MR sensor 34. Then, all four sensor legs can be used to construct a bridge circuit, with the net output signal now being the difference voltage between the two center tapped leads.

The invention has been described in detail with particular reference to preferred embodiments thereof, but it will be understood that variations and modifications can be effected within the spirit and scope of the invention. For example, an antiferromagnetic exchange pinning layer has been described, however it is also possible to use, in all cases, a ferrimagnetic exchange pinning layer such as TbCo.

## Claims

1. A magnetoresistive magnetic field sensor comprising:
a) a thin film magnetoresistive element of a layer of electrically conductive, ferromagnetic, anisotropically magnetoresistive material, said layer having a magnetic easy axis which coincides with the longitudinal axis of said element, said element having a longitudinal dimension which exceeds that of its transverse dimension,
b) any array of one or more lithographically patterned slanted strips of electrically conductive, anti- ferromagnetic or ferrimagnetic material in direct electrical contact with, and magnetically exchange coupled to said magnetoresistive layer, whereby said strips provide a unidirectional effective exchange field on said first magnetoresistive layer which is oriented along said longitudinal axis of said magnetoresistive element, and further wherein at least one edge of said slanted strips makes an acute angle Ψ with said longitudinal axis of said magnetoresistive element,
c) a nonmagnetic, electrically high conductivity material photolithographically configured geometrically congruent to, and overlaying said strip in direct electrical contact with said strip, and
d) means for making electrical contact to the end regions of said magnetoresistive element for the purpose of connection to an electrical excitation source.

2. The sensor of Claim 1 wherein said magnetoresistive layer is NiFe(PERMALLOY).

3. The sensor of Claim 1 or Claim 2 wherein said exchange coupling material is FeMn, NiMn or TbCo.

4. The sensor of Claim 1, 2 or 3 wherein said non magnetic, electrically high conductivity material comprises Au.

5. The sensor of any one of Claims 1 to 4 wherein said angle Ψ is between 20 and 70 degrees.

6. A magnetoresistive magnetic field sensor comprising:
a) a thin film magnetoresistive element of a layer of electrically conductive, ferromagnetic, anisotropically magnetoresistive material, said layer having a magnetic easy axis which coincides with the longitudinal axis of said element, said element having a longitudinal dimension which exceeds that of its transverse dimension,
b) means for making electrical contact to the center region of said magnetoresistive field sensor, wherein said magnetoresistive field sensor is geometrically equally divided into a first leg and a second leg,
c) a first array having one or more lithographically patterned slanted strips of electrically conductive, antiferromagnetic or ferrimagnetic material in direct electrical contact with said first leg and magnetically exchange coupled to said first magnetoresistive layer at said first leg, whereby said strips provide a unidirectional effective exchange field on said magnetoresistive layer which is oriented along said longitudinal axis of said magnetoresistive element, and further wherein at least one edge of said slanted strips of said first array makes an acute angle Ψ with said longitudinal axis of said magnetoresistive element,
d) a second array having one or more lithographically patterned slanted strips of electrically conductive, antiferromagnetic or ferrimagnetic material in direct electrical contact with said second leg and magnetically exchange coupled to said magnetoresistive layer at said second leg, whereby said strip provides a unidirectional effective exchange field on said magnetoresistive layer which is oriented along said longitudinal axis of said magnetoresistive element, and further wherein at least one edge of said slanted strips of said second array makes an angle supplemental to said angle Ψ with said longitudinal axis of said magnetoresistive element,
e) a non magnetic, electrically high conductivity material photolithographically configured to be geometrically congruent to, and overlaying said strip of said first array and said strip of said second array, said non magnetic, electrically high conductivity material being in direct electrical contact with said strip of said first array and said strip of said second array, and
f) means for making electrical contact to the end regions of said magnetoresistive element for the purpose of connection to an electrical excitation source.

7. The sensor of Claim 6 wherein said magnetoresistive layer is NiFe(PERMALLOY).

8. The sensor of Claim 6 or Claim 7 wherein said exchange coupling material is FeMn, NiMn or TbCo.

9. The sensor of Claim 6, 7 or 8 wherein said non magnetic, electrically high conductivity material comprises Au.

10. A magnetoresistive magnetic field sensor comprising:
a) a thin film magnetoresistive element of a layer of electrically conductive, ferromagnetic, anisotropically magnetoresistive material, said layer being configured as a first and second non collinear, parallel oriented legs, each of said legs having a magnetic easy axis which coincides with the longitudinal axis of said leg, and each of said legs having a longitudinal dimension which exceeds that of its transverse dimension,
b) means for making electrical contact with said first leg at a first longitudinal end of said first leg, said means for making electrical contact being further in contact with said second leg at a first longitudinal end of said second leg, wherein said means for making electrical contact forms a center tap common to said first leg and said second leg,
c) a first array having one or more lithographically patterned slanted strips of electrically conductive, antiferromagnetic or ferrimagnetic material in direct electrical contact with said first leg and magnetically exchange coupled to said magnetoresistive layer at said first leg, whereby said strips provide a unidirectional effective exchange field on said magnetoresistive layer which is oriented along said longitudinal axis of said magnetoresistive element, and further wherein at least one edge of said slanted strips of said first array makes an acute angle Ψ with said longitudinal axis of said first leg,
d) a second array having at one or more lithographically patterned slanted strip of electrically conductive, anti- ferromagnetic or ferrimagnetic material in direct electrical contact with said second leg and magnetically exchange coupled to said magnetoresistive layer at said second leg, whereby said strips provide a unidirectional effective exchange field on said magnetoresistive layer which is oriented along said longitudinal axis of said magnetoresistive element, and further wherein at least one edge of said slanted strips of said second array makes an acute angle Ψ, or makes an angle supplemental to said angle Ψ with said longitudinal axis of said second leg,
e) a non magnetic, electrically high conductivity material photolithographically configured to be geometrically congruent to, and overlaying said strip of said first array and said strip of said second array, said non magnetic, electrically high conductivity material being in direct electrical contact with said strip of said first array and said strip of said second array, and
f) means for making electrical contact to the end regions of said magnetoresistive element for the purpose of connection to an electrical excitation source.
